# EUROPEAN PATENT APPLICATION

(11) **EP 2 439 792 A1**
(43) Date of publication of application: **11.04.2012**
(21) Application number: 10186615.0
(22) Date of filing: 05.10.2010
(51) Int. Cl.: H01L 31/18, H01L 31/075

(54) **Thin-film solar cell fabrication process, deposition method for solar cell precursor layer stack, and solar cell precursor layer stack**

(71) Applicant: Applied Materials, Inc., Santa Clara, CA 95054 (US)
(72) Inventor: Klein, Stefan, 63743, Aschaffenburg (DE); Stolley, Tobias, 61440, Oberursel (DE); Buschbaum, Susanne, 63741 Aschaffenburg (DE); Rhode, Martin, 60385 Frankfurt (DE); Schwanitz, Konrad, 63739 Ascaffenburg (DE); Stoemmer, Christian, 63741 Aschaffenburg (DE)
(74) Representative: Zimmermann & Partner

(57) **Abstract**

A method of manufacturing a layer stack adapted for a thin-film solar cell and a precursor for a solar cell are described. The method includes depositing a TCO layer over a transparent substrate, depositing a first conductive-type layer of a first p-i-n junction configured for the solar cell, depositing a first intrinsic-type layer of a first p-i-n junction configured for the solar cell and depositing a further conductive-layer with a conductivity opposite to the first conductive-type layer of the first p-i-n junction configured for the solar cell. The method further includes providing for a SiOx-containing intermediate layer by chemical vapor deposition and depositing a second p-i-n junction configured for the solar cell, wherein the SiOx-containing intermediate layer is provided within the a further conductive-type layer, and wherein the SiOx-containing layer has a thickness of 17 nm or less.

## Description

### BACKGROUND OF THE INVENTION

### Field of the Invention

Embodiments of the present invention generally relate to depositing layers of a photoelectric conversion module, e.g. a thin-film solar cell. Particularly, they relate to a layer stack of a tandem-junction solar cell or a solar cell with a plurality of p-i-n junctions. Specifically, they relate to a layer stack for a thin-film solar cell and a method of manufacturing a layer stack adapted for a thin-film solar cell and a precursor for a solar cell.

### Description of the Related Art

Crystalline silicon solar cells and thin-film solar cells are two types of solar cells. Crystalline silicon solar cells typically use either mono-crystalline substrates (i.e., single-crystal substrates of pure silicon) or multi-crystalline silicon substrates (i.e., poly-crystalline or polysilicon). Additional film layers are deposited onto the silicon substrates to improve light capture, form the electrical circuits, and protect the devices. Thin-film solar cells use thin layers of materials deposited on suitable substrates to form one or more p-n junctions. Suitable substrates include glass, metal, and polymer substrates.

To expand the economic uses of solar cells, efficiency must be improved. Solar cell stabilized efficiency relates to the proportion of incident radiation converted into usable electricity. For solar cells to be useful for more applications, solar cell efficiency must be improved beyond the current best performance of approximately 10% for Si based thin-film solar modules. With energy costs rising, there is a need for improved thin-film solar cells and methods and apparatuses for forming the same in a factory environment.

In order to improve the efficiency of a solar cell, the amount of photons entering a solar cell layer stack, which are converted into electron-hole pairs should be increased.

Another aspect for improving mass production of solar cells is the use of large scale processes, increasing the throughput and improving the reliability at which processes can be conducted. Thus, there is a desire to improve the processes for increasing the efficiency on a large scale and for applications during industrial manufacturing.

### SUMMARY OF THE INVENTION

In light of the above, a method of manufacturing a layer stack adapted for a thin-film solar cell according to independent claim 1 and a precursor for a solar cell according to independent claim 6 are provided.

Embodiments of the invention provide methods of depositing layer stacks for photoelectric conversion devices, e.g. solar cells. According to one embodiment, method of manufacturing a layer stack adapted for a thin-film solar cell is provided. The method includes depositing a TCO layer over a transparent substrate, depositing a first conductive-type layer a first p-i-n junction configured for the solar cell, depositing a first intrinsic-type layer of a first p-i-n junction configured for the solar cell and depositing a further conductive-layer with a conductivity opposite to the first conductive-type layer first p-i-n junction configured for the solar cell. The method further includes providing for a SiOx-containing intermediate layer by chemical vapor deposition and depositing a second p-i-n junction configured for the solar cell, wherein the SiOx-containing intermediate layer is provided as a part of the further conductive-type layer, and wherein the SiOx-containing layer has a thickness of 17 nm or less.

According to another embodiment, a precursor for a solar cell is provided. The precursor includes a transparent substrate, a first conductive-type layer a first p-i-n junction configured for the solar cell, a first intrinsic-type layer of a first p-i-n junction configured for the solar cell, and a further conductive-layer with a conductivity opposite to the first conductive-type layer first p-i-n junction configured for the solar cell. The precursor further includes a SiOx-containing intermediate layer deposited by chemical vapor deposition and a second p-i-n junction configured for the solar cell, wherein the SiOx-containing intermediate layer is provided as a part of the further conductive-type layer, and wherein the SiOx-containing layer has a thickness of 17 nm or less.

### BRIEF DESCRIPTION OF THE DRAWINGS

So that the manner in which the above recited features of the present invention are attained and can be understood in detail, a more particular description of the invention, briefly summarized above, may be had by reference to the embodiments thereof, which are illustrated in the appended drawings.

Figure 1 is a schematic side-view of a tandem-junction thin-film solar cell according to one embodiment of the invention;

Figures 2 and 3 illustrate aspects of improving light conversion of a solar cell according to embodiments described herein;

Figures 4A to 4C illustrate the layers deposited on a substrate according to embodiments described herein;

Figures 5A and 5B illustrate further precursors for a solar cell having layers deposited on a substrate according to embodiments described herein;

Figure 6 is a flow-chart illustrating methods of manufacturing a solar cell precursor according to embodiments described herein;

Figure 7 illustrates a comparison of example;

Figure 8 illustrates a plan view of a cluster tool that may be used according to one embodiment described herein; and

Figure 9 is a cross-sectional side view of a deposition chamber which can be used according to one embodiment described herein.

To facilitate understanding, identical reference numerals have been used, where possible, to designate identical or similar elements that are common to the figures. It is contemplated that elements and features of one embodiment may be beneficially incorporated into other embodiments without further recitation.

It is to be noted, however, that the appended drawings illustrate only exemplary embodiments of this invention and are therefore not to be considered limiting of its scope, for the invention may admit to other equally effective embodiments.

### DETAILED DESCRIPTION

Reference will now be made in detail to the various embodiments of the invention, one or more examples of which are illustrated in the figures. Each example is provided by way of explanation of the invention and is not meant as a limitation of the invention. For example, features illustrated or described as part of one embodiment can be used on or in conjunction with other embodiments to yield yet a further embodiment. It is intended that the present invention includes such modifications and variations.

The term "substrate" as used herein shall embrace both inflexible substrates, e.g. a wafer, a transparent substrate, or a glass substrate such as a glass plate, and flexible substrates such as webs and foils.

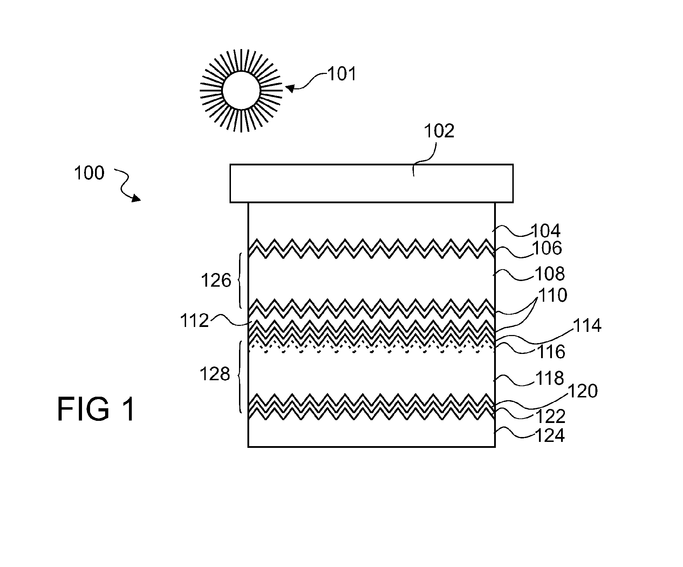

Embodiments described herein relate to a solar cell precursor and methods of manufacturing thereof, wherein a top cell and a bottom cell are used and an intermediate layer is provided such that, for example, light absorption in the respective top or bottom cell can be improved. Thereby, reference is, for example, made to the solar cells as described below and explained in further detail with respect to Fig. 1.

Thin-film solar cells are generally formed from numerous types of films, or layers, combined in many different ways. Most films used in such devices incorporate a semiconductor element that may include silicon, germanium, carbon, boron, phosphorous, nitrogen, oxygen, hydrogen and the like. Characteristics of the different films include degree of crystallinity, dopant type, dopant concentration, film refractive index, film extinction coefficient, film transparency, film absorption, and conductivity. Typically, most of these films can be formed by use of a chemical vapor deposition process, which may include some degree of ionization, plasma formation and/or sputtering processes.

The term "coating" and the term "depositing" are used synonymously herein. The terms "CVD installation" and "deposition apparatus" are used synonymously herein and shall embrace for example an apparatus which uses CVD processes for depositing material, typically as a thin film, on a substrate.

According to different embodiments, a plurality of films can be used in solar cells. Charge generation during a photovoltaic process is generally provided by a bulk semiconductor layer, such as a silicon-containing layer. The bulk layer is also sometimes called an intrinsic layer to distinguish it from the various doped layers present in the solar cell. The intrinsic layer may have any desired degree of crystallinity, which will influence its light-absorbing characteristics. For example, an amorphous intrinsic layer, such as amorphous silicon, will generally absorb light at different wavelengths from intrinsic layers having different degrees of crystallinity, such as microcrystalline silicon. For this reason, most solar cells will use both types of layers to yield the broadest possible absorption characteristics. In some instances, an intrinsic layer may be used as a buffer layer between two dissimilar layer types to provide a smoother transition in optical or electrical properties between the two layers.

Silicon and other semiconductors can be formed into solids having varying degrees of crystallinity. Solids having essentially no crystallinity are amorphous, and silicon with negligible crystallinity is referred to as amorphous silicon. Completely crystalline silicon is referred to as crystalline, polycrystalline, or monocrystalline silicon. Polycrystalline silicon is crystalline silicon formed into numerous crystal grains separated by grain boundaries. Monocrystalline silicon is a single crystal of silicon. Solids having partial crystallinity, that is a crystal fraction between about 5% and about 95%, are referred to as nanocrystalline or microcrystalline, generally referring to the size of crystal grains suspended in an amorphous phase. Solids having larger crystal grains are referred to as microcrystalline, whereas those with smaller crystal grains are nanocrystalline. It should be noted that the term "crystalline silicon" may refer to any form of silicon having a crystal phase, including microcrystalline and nanocrystalline silicon.

FIG. 1 is a schematic diagram of an embodiment of a multi-junction solar cell 100 oriented toward the light or solar radiation 101. Solar cell 100 includes a substrate 102, such as a glass substrate, polymer substrate, metal substrate, or other suitable substrate, with thin films formed thereover. The solar cell 100 further includes a first transparent conducting oxide (TCO) layer 104 formed over the substrate 102, and a first p-i-n junction 126 formed over the first TCO layer 104. In one configuration, a wavelength selective reflector (WSR) layer 112 is formed over the first p-i-n junction 126. A second p-i-n junction 128 is formed over the first p-i-n junction 126, a second TCO layer 122 is formed over the second p-i-n junction 128, and a metal back layer 124 is formed over the second TCO layer 122. In one embodiment, a WSR layer 112 is disposed as a part of the second conductive-type layer of the first p-i-n junction, i.e. within the layer 110 or between the first p-i-n junction 126 and the second p-i-n junction 128, and is configured to have film properties that improve light scattering and current generation in the formed solar cell 100. Additionally, the WSR layer 112 also provides a good p-n tunnel junction that has a high electrical conductivity and a tailored bandgap range that affects its transmissive and reflective properties to improve the formed solar cell's light conversion efficiency.

To improve light absorption by enhancing light trapping, the substrate and/or one or more of the thin films formed thereover may be optionally textured by wet, plasma, ion etching, and/or mechanical processes. For example, in the embodiment shown in FIG. 1, the first TCO layer 104 is textured and the subsequent thin films deposited thereover will generally follow the topography of the surface below it.

According to some embodiments described herein, a further layer such as a buffer layer is deposited between the substrate 102 and the TCO layer 104. Thereby, typically, the further layer can be a SiON-containing layer. The further layer is provided in order to have an improved nucleation of the transparent conductive oxide (TCO) layer, such as a ZnO-containing TCO layer. Accordingly, the substrate including, e.g., a buffer layer is conditioned for improved ZnO growth. According to embodiments described herein, the further layer includes a metal such as Al, Ti, Zn, or the like. Thereby, nucleation of the TCO layer can be influenced to provide for improved texturing and desired electrical and optical properties of the TCO layer. According to some embodiments, the conditioning can be conducted by depositing or preparing a metal-containing layer, e.g. that the layer is doped with a metal.

The first TCO layer 104 and the second TCO layer 122 may each include tin oxide, zinc oxide, indium tin oxide, cadmium stannate, combinations thereof, or other suitable materials. It is understood that the TCO materials may also include additional dopants and components. For example, zinc oxide may further include dopants such as aluminum, gallium, boron, and other suitable dopants. Zinc oxide preferably includes 5 atomic % or less of dopants, and more preferably includes 2.5 atomic % or less aluminum. In certain instances, the substrate 102 may be provided by the glass manufacturers with the first TCO layer 104 already provided.

The first p-i-n junction 126 may include a p-type amorphous silicon layer 106, an intrinsic-type amorphous silicon layer 108 formed over the p-type amorphous silicon layer 106, and an n-type microcrystalline silicon layer 110 formed over the intrinsic-type amorphous silicon layer 108. In certain embodiments, the p-type amorphous silicon layer 106 may be formed to a thickness between about 60Å and about 300Å. In certain embodiments, the intrinsic-type amorphous silicon layer 108 may be formed to a thickness between about 1,500Å and about 3,500Å. In certain embodiments, the n-type microcrystalline semiconductor layer 110 may be formed to a thickness between about 100Å and about 400Å.

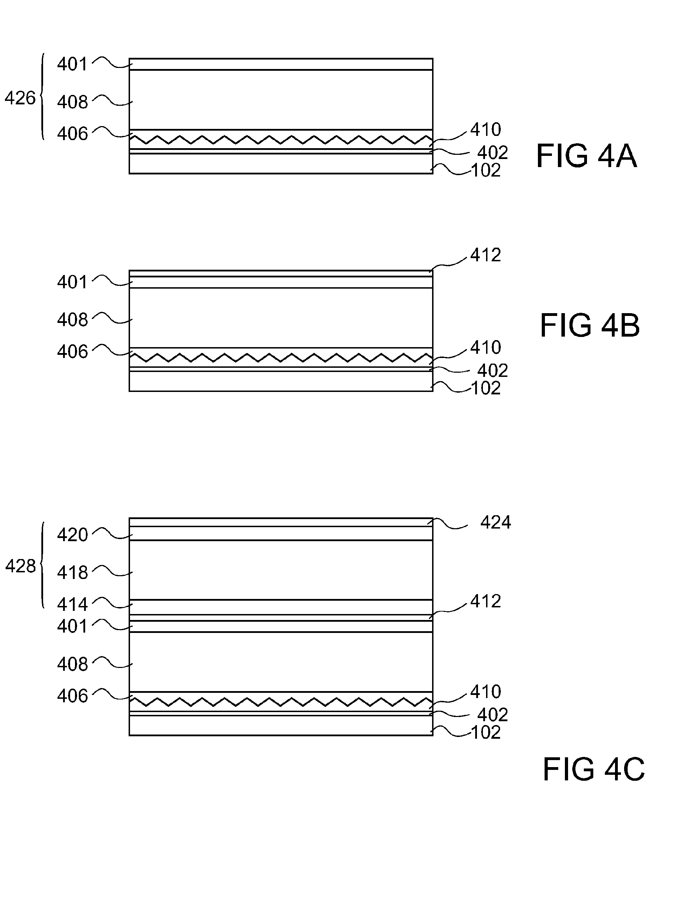

The WSR layer 112 disposed as a part of the n-type microcrystalline silicon layer 110, i.e. within the n-type microcrystalline silicon layer 110 or between the first p-i-n junction 126 and the second p-i-n junction 128 is generally configured to have certain desired film properties. In this configuration the WSR layer 112 actively serves as an intermediate reflector having a desired refractive index, or ranges of refractive indexes, to reflect light received from the light incident side of the solar cell 100. The WSR layer 112 also serves as a junction layer that boosts the absorption of the short to mid wavelengths of light (e.g., 400 nm to 700 nm) in the first p-i-n junction 126 and improves short-circuit current, resulting in improved quantum and conversion efficiency. Further, the WSR layer 112 has high film transmittance for mid to long wavelengths of light (e.g., 500nm to 1100nm) to facilitate the transmission of light to the layers formed in the junction 128. Further, it is generally desirable for the WSR layer 112 to absorb as little light as possible while reflecting desirable wavelengths of light (e.g., shorter wavelengths) back to the layers in the first p-i-n junction 126 and transmitting desirable wavelengths of light (e.g., longer wavelengths) to the layers in the second p-i-n junction 128. Details of the WSR layer will be described with reference to Figures 4A to 6 below.

The second p-i-n junction 128 may include a p-type microcrystalline silicon layer 114 and, in some cases, an optional p-i buffer-type intrinsic amorphous silicon (PIB) layer 116 that is formed over the p-type microcrystalline silicon layer 114. Subsequently, an intrinsic-type microcrystalline silicon layer 118 is formed over the p-type microcrystalline silicon layer 114, and an n-type amorphous silicon layer 120 is formed over the intrinsic type microcrystalline silicon layer 118. In certain embodiments, the p-type microcrystalline silicon layer 114 may be formed to a thickness between about 100Å and about 400Å. In certain embodiments, the p-i buffer-type intrinsic amorphous silicon (PIB) layer 116 may be formed to a thickness between about 50 Å and about 500 Å. In certain embodiments, the intrinsic-type microcrystalline silicon layer 118 may be formed to a thickness between about 10,000Å and about 20,000Å. In certain embodiments, the n-type amorphous silicon layer 120 may be formed to a thickness between about 100Å and about 500Å.

The metal back layer 124 may include, but is not limited to a material selected from the group consisting of Al, Ag, Ti, Cr, Au, Cu, Pt, alloys thereof, or combinations thereof. Other processes may be performed to form the solar cell 100, such as laser scribing processes. Other films, materials, substrates, and/or packaging may be provided over the metal back layer 124 to complete the solar cell device. The formed solar cells may be interconnected to form modules, which in turn can be connected to form arrays.

Solar radiation 101 is primarily absorbed by the intrinsic layers 108, 118 of the p-i-n junctions 126, 128 and is converted to electron-hole pairs. The electric field created between the p-type layer 106, 114 and the n-type layer 110, 120 that stretches across the intrinsic layer 108, 118 causes electrons to flow toward the n-type layers 110, 120 and holes to flow toward the p-type layers 106, 114 creating a current. According to some embodiments, which can be combined with other embodiments described herein, the first p-i-n junction 126 includes an intrinsic type amorphous silicon layer 108 and the second p-i-n junction 128 includes an intrinsic type microcrystalline silicon layer 118 since amorphous silicon and microcrystalline silicon absorb different wavelengths of the solar radiation 101. Therefore, the formed solar cell 100 is more efficient, since it captures a larger portion of the solar radiation spectrum. The intrinsic layer 108, 118 of amorphous silicon and the intrinsic layer of microcrystalline silicon are stacked in such a way that solar radiation 101 first strikes the intrinsic type amorphous silicon layer 118 and is transmitted through the WSR layer 112 and then strikes the intrinsic type microcrystalline silicon layer 118 since amorphous silicon has a larger bandgap than microcrystalline silicon. Solar radiation not absorbed by the first p-i-n junction 126 continuously transmits through the WSR layer 112 and continues to the second p-i-n junction 128.

Charge collection is generally provided by doped semiconductor layers, such as silicon layers doped with p-type or n-type dopants. P-type dopants are generally group III elements, such as boron or aluminum. N-type dopants are generally group V elements, such as phosphorus, arsenic, or antimony. In most embodiments, boron is used as the p-type dopant and phosphorus as the n-type dopant. These dopants may be added to the p-type and n-type layers 106, 110, 114, 120 described above by including boron-containing or phosphorus-containing compounds in the reaction mixture. Suitable boron and phosphorus compounds generally include substituted and unsubstituted lower borane and phosphine oligomers. Some suitable boron compounds include trimethylboron (B(CH₃)₃ or TMB), diborane (B₂H₆), boron trifluoride (BF₃), and triethylboron (B(C₂H₅)₃ or TEB). Phosphine is the most common phosphorus compound. The dopants are generally provided with carrier gases, such as hydrogen, helium, argon, and other suitable gases. If hydrogen is used as the carrier gas, it adds to the total hydrogen in the reaction mixture. Thus hydrogen ratios will include hydrogen used as a carrier gas for dopants.

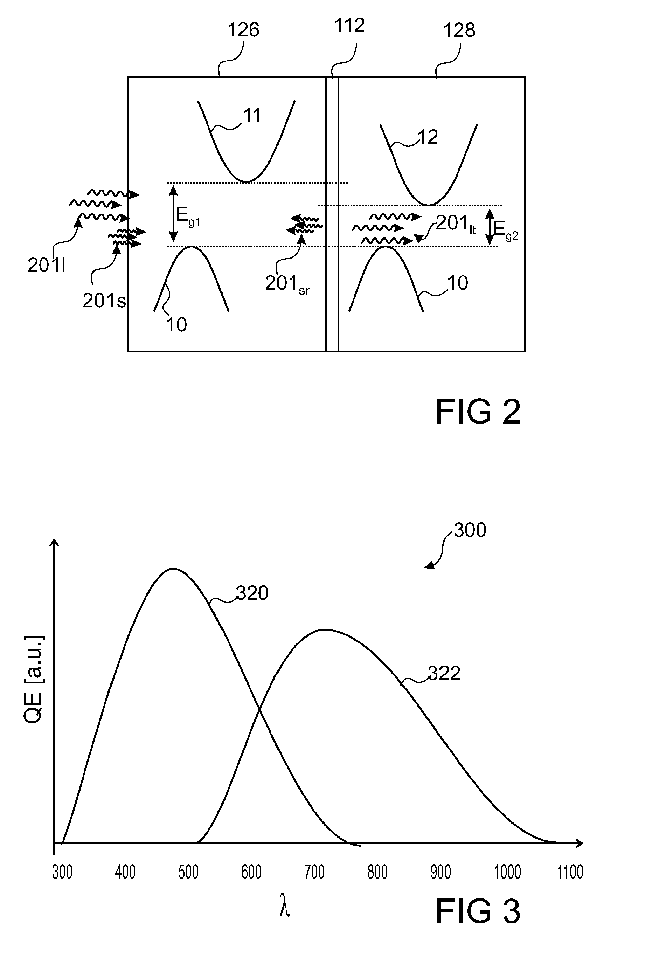

According to different embodiments, a plurality of methods, systems, and apparatus configurations for providing a precursor for a solar cell having an interlayer between a top cell and a bottom cell are provided. Figure 2 illustrates an arrangement of a first p-i-n junction 126, an intermediate layer 112, and a second p-i-n junction 128. In the schematic view shown in figure 2, the transparent substrate would be arranged on the left side of the first p-i-n junction. In light of the fact that this side would generally face the sun for entering photons, it can, thus, also be referred to as the top cell. The band structure of the light absorbing layers in the top cell 126 and the bottom cell 128 are schematically indicated in figure 2 by showing the valence band 10 and the conductive bands 11 and 12, respectively.

Thereby, as illustrated by the first band gap E_{g1} and the second band gap E_{g2}, the band gap in the top cell 126 is larger than the band gap in the bottom cell 128. Figure 2 shows photons 201ₗ with a longer wavelength and 201ₛ with a shorter wavelength. The longer wavelength corresponds to a smaller energy such that the photons 201ₗ are not absorbed in the top cell 126. Photons 201₁ with a longer wavelength are transmitted through the top cell 126 as indicated by photons 201ₗₜ. It is desirable that the photons 201ₛ are reflected at the intermediate layer 112 such that photons, which are not absorbed when traversing the active layer of the top cell 126 for the first time, will pass through the active layer again in order to increase the probability for generating an electron-hole pair. This is indicated by reference 201ₛᵣ showing reflected photons with a short wavelength.

Figure 3 shows a graph 300 depicting the quantum efficiency as a function of the wavelength. Thereby, the quantum efficiency for the shorter wavelength in the first p-i-n junction 126 is indicated by function 320. The quantum efficiency for the second p-i-n junction 128 for the longer wavelength is indicated by function 322.

In a stacked-layer type photoelectric conversion device, the photoelectric conversion units, i.e. the top cell 126 and the bottom cell 128 are connected in series. The short-circuit current density of the photoelectric conversion device is restricted by the smaller of the current values of the top cell and the bottom cell. Thus, it is beneficial if the current values of the first and second p-i-n junctions are as equal as possible. Accordingly, it is desirable to tune the first function 320 and the second function 322 with respect to each other. This can be achieved by providing an intermediate layer 112 according to the embodiments described herein. Thereby, the intermediate layer should preferably reflect short wavelength photons and should transmit long wavelength photons with minimal loss. Additionally, in light of the fact that the top cell and the bottom cell are connected in series, the intermediate layer 112 should have good conductive properties. Accordingly, a combination of conductivity, reflecting photons of a desired wavelength range and transmitting photons of another wavelength range is desirable.

Common intermediate layers are often formed from a transparent conductive oxide. However, if for example a zinc oxide intermediate layer is used, an additional sputtering tool would be required between the CVD processes of forming the first p-i-n junction and a second p-i-n junction. It has also been proposed to use a silicon composite layer with an oxygen concentration of more than 25 atomic % and less than 60 atomic % and including silicon-rich face parts in an amorphous alloy phase of silicon and oxygen, wherein the intermediate layer has a thickness of 20 nm or more. The inventors have found that an intermediate layer with a thickness of 17 nm or below, of 15 nm or below or even of 12 nm provides improved cell efficiency. For example, the thickness can be from 5 nm to 17 nm.

According to different embodiments, which can be combined with other embodiments described herein, the first conductivity-type layer, the i-layer and the second conductivity-type layer having a conductivity opposite to the first conductivity-type layer form a p-i-n junction, respectively. The examples provided herein generally refer to p-i-n junctions, wherein the first conductivity-type layer is a p-layer and the second conductivity-type layer is an n-layer. It is to be understood that the first conductivity-type layer can also be an n-layer and the second conductivity-type layer can be a p-layer. Thereby, also a p-i-n junction, which would then be inverted, can be formed.

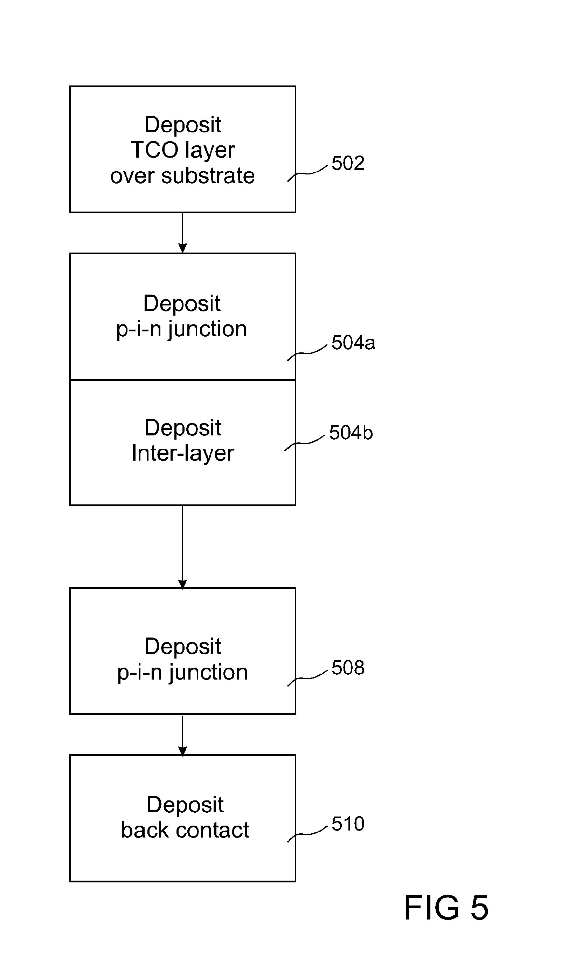

Typical embodiments of a solar cell precursor such as a layer stack for a thin-film solar cell and the manufacturing thereof are illustrated in figures 4A to 4C and in figure 5. As shown in figure 4A, a plurality of layers can be provided over the substrate 102. Thereby, the buffer layer 402 can be provided on the substrate 102. According to some embodiments described herein, a further layer such as a buffer layer 402 is deposited between the substrate 102 and the TCO layer 410. Thereby, typically, the further layer can be a SiON-containing layer. The further layer is provided in order to have an improved nucleation of the transparent conductive oxide (TCO) layer, such as a ZnO-containing TCO layer. Accordingly, the substrate including, e.g., a buffer layer is conditioned for improved ZnO growth. According to embodiments described herein, the further layer includes a metal such as Al, Ti, Zn, or the like. Thereby, according to some additional or alternative modification, the layer 403 can have a thickness of below 100 nm, for example a thickness of 20 nm to 100 nm or of 50 nm to 90 nm. According to further embodiments, which can be combined with other embodiments described herein, the layer 402 can have a refraction index which is between the refraction indexes of the two neighboring layers, e.g. the refraction index of the substrate 102 below layer 402 and the refraction index of the TCO layer 410. For example, the refraction index can be from 1.6 to 1.8. According to yet further embodiments, which can be combined with other embodiments described herein, the layer 402 can be used as a barrier for the diffusion of elements, e.g. a diffusion barrier for sodium (Na), which can be present in the substrate. For example, the layer can be a diffusion barrier which provides improved long-term stability or improved reliability. For example, the layer acting as a diffusion barrier can enable the layer stack to pass a delamination test such as the hot-tray test. Accordingly, a buffer layer can improve nucleation of the TCO layer to provide for improved texturing and desired electrical, chemical and optical properties of the TCO layer.

Thereafter, the TCO layer 410, for example a doped ZnO layer is provided over the substrate as indicated by step 502 in figure 5. Figure 4A shows the TCO layer 410 being textured for improved light trapping. Typically, a doped ZnO layer is deposited by a DC-sputtering process as a TCO front contact with a thickness of about 800 - 1000 nm. The dopant can be, but is not limited to, aluminum. Finally, the layer stack is etched in diluted acid in order to roughen the ZnO surface by wet etching. The textured transparent conductive oxide layer can have a layer thickness of, for example, 400 nm to 700 nm, typically 400 nm to 600 nm, wherein the thickness of the texture surface is measured with X-ray fluorescence (XRF).

Examples of a TCO layers, particularly ZnO-containing TCO layers are described in patent application Ser. No. 12/854,469, entitled " Thin film solar fabrication process, deposition method for TCO layer, and solar cell precursor layer stack" filed August 11, 2010 and U.S. patent application Ser. No. 12/840,039, entitled " Thin Film Solar Fabrication Process, Deposition method for TCO layer, and Solar cell precursor layer stack" filed July 20, 2010, both of which are incorporated herein by reference to the extent the applications are not inconsistent with this disclosure.

In steps 504a and 504b a first p-i-n junction is deposited. The first p-i-n junction corresponds to the p-type layer 406, the i-type layer 408, and the n-type layer 401. These layers can, for example, be provided as explained in more detail with respect to figure 1 above. As a part of the n-type layer of the first p-i-n junction 426, an intermediate layer is deposited in step 506. Figure 4B shows intermediate layer 412. According to some embodiments, which can be combined with other embodiments described herein, the intermediate layer 412, which can be a part of the n-layer 110, can be positioned such that it is between the first p-i-n junction and the second p-i-n junction. Alternatively, the intermediate layer can also be provided such that it is within the layer 401. A second p-i-n junction 428 is deposited in step 508 before the back contact 424 is deposited in step 510. Thereby, the second p-i-n junction 428 includes a p-type layer 414, an intrinsic layer 418, and an n-type layer 420. Further details with regard to the second p-i-n junction 428 have been described abnove with respect to figure 1.

According to embodiments described herein, the intermediate layer 412 is provided as a silicon oxide layer such as a SiOx layer. Typically, the SiOx layer is deposited as a part of the last layer of the first p-i-n junction (top cell).

According to further embodiments, which may be combined with other embodiments described herein, the SiOx layer can be deposited by adding CO2 in the processing region of the CVD processing chamber. Thereby, according to yet further embodiments, a solar cell precursor having an intermediate layer with a refraction index of 2.5 or lower can be provided. Accordingly, the reflection and transmission properties, which have been discussed above with respect to Figs. 2 and 3, can be provided for a solar cell precursor and for a method of manufacturing a layer stack for a thin-film solar cell.

Typically, by variation of the oxygen content in the intermediate layer various properties of the layer can be tuned. Thus, according to methods described herein the CO2 content in the process gas can be varied for optimizing the process and can typically be in a range of 50 sccm to 300 sccm for manufacturing a GEN 5 module, which results in about 35 sccm/m² per substrate area to about 210 sccm/m² per substrate area. By increasing the CO2 concentration in the processing region as described above, the refraction index can for example be reduced from about 3.0 to about 2.2, while the band gap is increased from about 2.15 eV to about 2.45 eV, the conductivity is reduced from about 1*10⁻³ S/cm² to about 5*10⁻⁹ S/cm², and the crystalline fraction is reduced from about 0.16 to 0.

According to typical embodiments described herein, which may be combined with other embodiments described herein, the intermediate layer can have at least one of the following characteristics selected from the group consisting of: a refraction index of 2.5 or below, a thickness of 13 nm to 17 nm (e.g. 15 nm), a crystalline fraction of 5% to 10%, a conductivity of 1*10⁻³ S/cm² to about 5*10⁻⁹ S/cm², and a band gap of 1.5 eV to 3.0 eV. According to typical embodiments for manufacturing the layer stack, at least one of the steps can be provided, which are selected from the group: providing a CO2 gas flow of 20 sccm to 500 sccm, providing a ratio of CO2/silane gas flow of 1.5 to 4, and providing RF power of 1000 W to 8000 W for the CVD process.

The above described embodiments refer to a tandem junction having a first and a second p-i-n junction, e.g. a top cell and a bottom cell, and an intermediate layer there between. However, this is not to be understood as limiting to the invention. According to modifications thereof, additionally a third, forth or fifth p-i-n junction can be provided, wherein according to typical modifications between one or more boundaries of the further p-i-n junctions a corresponding interlayer is provided, i.e. an interlayer with properties designed for the desired characteristic between the two adjacent p-i-n junction.

According to embodiments described herein, a precursor for a solar cell is deposited on an industrially-relevant scale. For example, the layers of some embodiments described herein can be deposited on an area of 1 m² and above, 4 m² and above or 5 m² and above. Thereby, the surface on which the layers are to be deposited and the layers itself need to be provided with a predetermined uniformity on a large scale. According to some embodiments, which can be combined with other embodiments described herein, the solar cell precursors, the layer stacks for solar cells and the methods and devices for manufacturing layers can be utilized for large-area thin films. For example, substrate sizes of 1.43 m² (Gen5) and above, such as 5.7 m² (Gen8.5) or larger, can be realized.

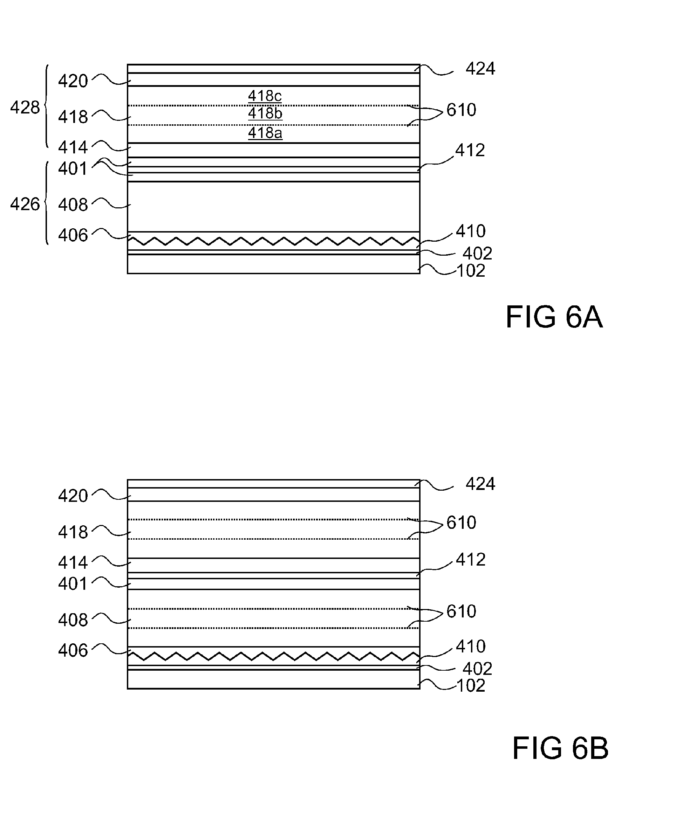

According to yet further embodiments, which can be combined with other embodiments described herein, the above-described intermediate layer, or interlayer, which is provided between a first and a second p-i-n junction can be provided in combination with a hydrogen-diluted grading. Corresponding embodiments are illustrated in Figs. 6A and 6B. As already described with respect to Figs. 4A to 4C, a plurality of layers can be provided over the substrate 102. Thereby, the buffer layer 402, a TCO layer 410, a top cell 426, and intermediate layer 412, a bottom cell 428, and a back contact 424 can be provided over the substrate 102. As shown in Fig. 6A the intermediate layer 412 is deposited within the layer 401. These layers can be provided as elsewhere described herein. In Fig. 6A, the bottom cell 428 includes a hydrogen-dilution grading as indicated by dotted lines 610. Thereby, during deposition of the intrinsic layer 418, the process gas is diluted with hydrogen. Typically, a grading can be provided by having a silane-to-hydrogen ratio between 15:1 and 2:1. The grading can be provided by interrupting the CVD (e.g, the PECVD) process during deposition of the intrinsic layer, which can typically be an intrinsic-type amorphous silicon layer 418, varying the silane-to-hydrogen ratio and continuing with the deposition process at the varied silane-to-hydrogen ratio. Thereby, according to typical embodiments, the pressure in the deposition chamber might be lowered to a pressure lower than the deposition pressure before providing the silane-to-hydrogen ratio desired for the subsequent grading sub-layer.

As shown in Fig. 6A three grading steps 418a, 418b and 418c can be provided. According to yet further embodiments, which can be combined with other embodiments described herein, two grading steps or four, five or more grading steps might also be provided. According to yet further embodiments, the grading can also be provided as a continuous hydrogen dilution gradient within the intrinsic-type layer 418.

A further embodiment is shown in Fig. 6B, wherein a hydrogen dilution grading is provided for the intrinsic-type layer of the top cell 426 and the bottom cell 428. As shown in Fig. 6B the intermediate layer 412 is deposited between the the further conductive-type layer 401 and the first layer of the bottom cell. According to yet further options, the hydrogen dilution grading can also be provided in the top cell only, or, if present, in one or more further p-i-n junctions.

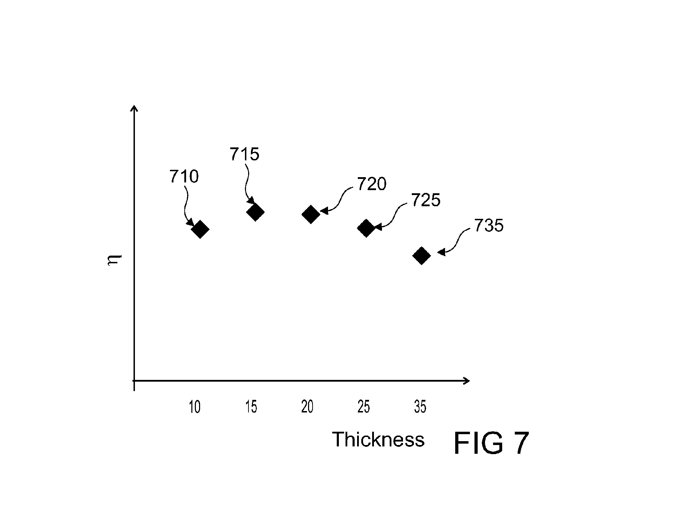

Figure 7 illustrates a plurality of examples, wherein different intermediate layer thickness have been compared. The graph shows the cell efficiency in arbitrary units as a function of the thickness of the layer. Thereby, five values 710-735 are shown. The examples have been manufactured on GEN5 substrates with a transparent Al-doped ZnO TCO layer with a thickness of 270 nm and an Al back contact of 1650 nm. The intrinsic layers have been provided with a hydrogen dilution grading and the top cell and the bottom cell have been deposited as follows.

An intermediate SiOx layer acting as wavelength selective reflector and as a conducting layer between the top cell and the bottom cell has been provided by PECVD and flowing a gas mixture having silane, hydrogen, phosphine and CO2 in the deposition region. The SiOx layer has been tuned to have a refraction index of 2.3. The comparison of different thicknesses of the intermediate layer shows that the efficiency of a solar cell manufactured from a respective precursor for a solar cell and according to a method of manufacturing a layer stack shows that an improved cell efficiency can be realized for intermediate layer thickness of about 17 nm or below. Thereby, it should be note that the reduced value for 10 nm has been identified to be based on non-operative single cells within a layer stack.

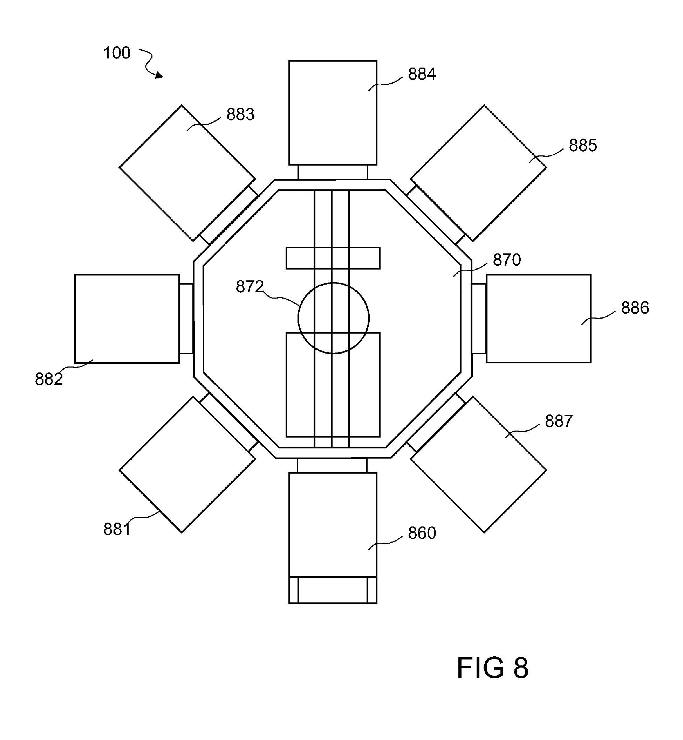

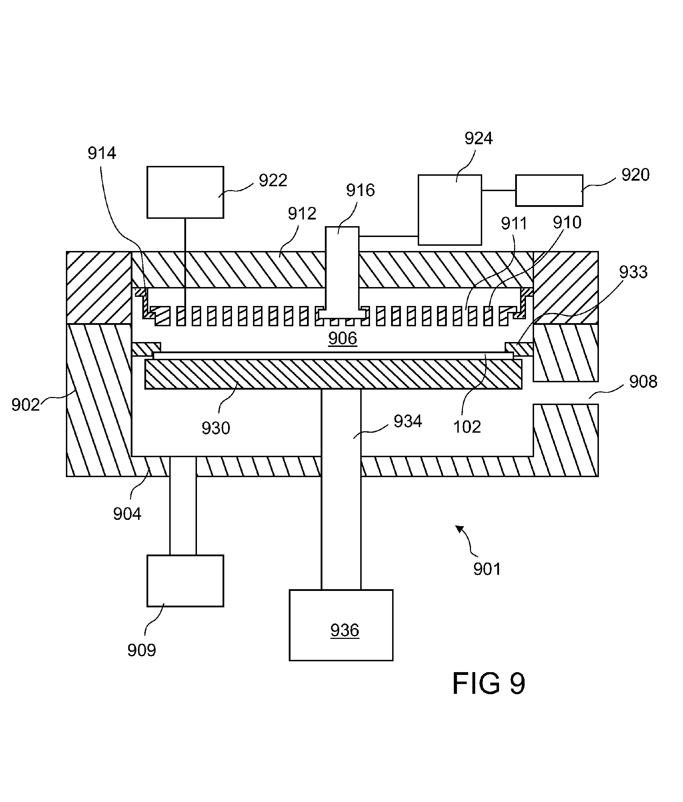

Figures 8 and 9 illustrate a processing system 800 and a processing chamber 901 that may be used to form a portion of the solar cell, discussed above. Figure 8 is a top schematic view of one embodiment of a processing system 800, which may be one of the one or more cluster tools. The processing system 800 can thus be used to perform one or more processing steps that are used to form the various layers or regions of the solar cell device. The processing system 800 will generally contain a plurality of process chambers 881-887, such as a plasma enhanced chemical vapor deposition (PECVD) chamber 901 (Figure 9), capable of depositing one or more desired layers onto the substrate surface. The process system 800 includes a transfer chamber 870 coupled to a load lock chamber 860 and the process chambers 881-887. The load lock chamber 860 allows substrates to be transferred between the ambient environment outside the system and the vacuum environment within the transfer chamber 870 and process chambers 881-887. The load lock chamber 860 includes one or more evacuatable regions holding one or more substrates. The evacuatable regions are pumped down during input of substrates into the system 800 and are vented during output of the substrates from the system 800. The transfer chamber 870 has at least one vacuum robot 872 disposed therein that is adapted for transferring substrates between the load lock chamber 860 and the process chambers 881-887. While seven process chambers are shown in Figure 8, the system 800 may have any suitable number of process chambers.

Figure 9 is a schematic cross-section view of one embodiment of a processing chamber, such as a PECVD chamber 901, in which one or more films of a solar cell may be deposited. One suitable plasma enhanced chemical vapor deposition chamber is available from Applied Materials, Inc., located in Santa Clara, CA. It is contemplated that other deposition chambers, such as hot wire chemical vapor deposition (HWCVD), low-pressure chemical vapor deposition (LPCVD), physical vapor deposition (PVD), evaporation, or other similar devices, including those from other manufacturers, may be utilized to practice the present invention. In one embodiment, the chamber 901 generally includes walls 902, a bottom 904, a showerhead 910, and a substrate support 930 which define a process volume 906. The process volume is accessed through a valve 908 such that the substrate, such as substrate 102, may be transferred in and out of the PECVD chamber 901. The substrate support 930 includes a substrate receiving surface for supporting a substrate and stem 934 coupled to a lift system 936 to raise and lower the substrate support 930. A shadow frame 933 may be optionally placed over the periphery of the device substrate that may already have one or more layers formed thereon, for example, the TCO layer. Lift pins can be moveably disposed through the substrate support 930 to move a substrate to and from the substrate receiving surface. The substrate support 930 may also include heating and/or cooling elements to maintain the substrate support 930 at a desired temperature. The substrate support 930 may also include grounding straps to provide RF grounding at the periphery of the substrate support 930. Examples of grounding straps are disclosed in U.S. Patent 6,024,044 issued on Feb. 15, 2000 to Law et al. and U.S. Patent Application 11/613,934 filed on Dec. 20, 2006 to Park et al., which are both incorporated by reference in their entirety to the extent not inconsistent with the present disclosure.

The showerhead 910 is coupled to a backing plate 912 at its periphery by a suspension 914. The showerhead 910 may also be coupled to the backing plate by one or more center supports 916 to help prevent sag and/or to control the straightness/curvature of the showerhead 910. A gas source 920 is coupled to the backing plate 912 to provide gas through the backing plate 912 and through the plurality of holes 911 in the showerhead 910 to the substrate receiving surface. A vacuum pump 909 is coupled to the PECVD chamber 901 to control the process volume 906 at a desired pressure. An RF power source 922 is coupled to the backing plate 912 and/or to the showerhead 910 to provide an RF power to the showerhead 910 so that an electric field is created between the showerhead and the substrate support so that a plasma may be generated from the gases between the showerhead 910 and the substrate support 930. Various RF frequencies may be used, such as a frequency between about 0.3 MHz and about 200 MHz. In one embodiment the RF power source is provided at a frequency of 13.56 MHz. Examples of showerheads are disclosed in U.S. Patent 6,477,980 issued on November 12, 2002 to White et al., U.S. Publication 20050251990 published on November 17, 2006 to Choi et al., and U.S. Publication 2006/0060138 published on March 23, 2006 to Keller et al, which are all incorporated by reference in their entirety to the extent not inconsistent with the present disclosure.

A remote plasma source 924, such as an inductively coupled remote plasma source, may also be coupled between the gas source and the backing plate. Between processing substrates, a cleaning gas may be provided to the remote plasma source 924 so that a remote plasma is generated and provided to clean chamber components. The cleaning gas may be further excited by the RF power source 922 provided to the showerhead. Suitable cleaning gases include but are not limited to NF3, F2, and SF6. Examples of remote plasma sources are disclosed in U.S. Patent 5,788,778 issued August 4, 1998 to Shang et al, which is incorporated by reference to the extent not inconsistent with the present disclosure.

Referring back to Figure 8, in one embodiment of the system 800, one of the process chambers 881-887 is configured to deposit a p-type silicon layer(s) of a first p-i-n junction 126 or a second p-i-n junction 128 of a solar cell device, another one of the process chambers 881-887 is configured to deposit an intrinsic silicon layer of the first or the second p-i-n junction, and another of the process chambers 881-887 is configured to deposit the n-type silicon layer(s) of the first or the second p-i-n junction. While a three chamber process configuration may have some contamination control advantages, it will generally have a lower substrate throughput than a two chamber processing system, and generally cannot maintain a desirable throughput when one or more of the processing chambers is undergoing for maintenance.

In one embodiment, which can be combined with other embodiments described herein, one of the process chambers 881-887 is configured to deposit the p-type silicon layer(s) of the first p-i-n junction while the remaining process chambers 881-887 are each configured to deposit both the intrinsic-type amorphous silicon layer(s) and the n-type silicon layer(s) of the first p-i-n junction. In one embodiment, the intrinsic-type amorphous silicon layer(s) and the n-type silicon layer(s) of the first p-i-n junction 126 may be deposited in the same chamber without performing a passivation process, which is used to minimize cross-contamination between the deposited layers, in between the deposition steps. While the discussion of the processing system 800 and its components references its use in forming the various elements of the first p-i-n junction, this configuration is not intended to be limiting as to the scope of the invention described herein, since the processing system 800 could be adapted to form the first p-i-n junction, the second p-i-n junction, both the first and second p-i-n junctions, the intermediate layer, or other combinations thereof without deviating from the basic scope of the invention described herein.

In one example, in which the substrate processing sequence is performed in a system configured similarly to the processing system 800, a substrate enters the processing system 800 through the load lock chamber 860. The substrate is then transferred by the vacuum robot 872 into the process chamber 881 that is configured to deposit a p-type silicon layer(s) on the substrate. After depositing the p-type layer in process chamber 881, the substrate is then transferred by the vacuum robot 872 into the process chamber 884 that is configured to deposit both the intrinsic-type silicon layer(s) and the n-type silicon layer(s). After depositing the intrinsic-type layer(s) and n-type layer(s) in process chamber 884, the intermediate layer is deposited after the substrate is transfererd to chamber 885, before a second p-i-n junction is deposited and the substrate is returned to the load lock chamber 460, after which the substrate can be removed from the system. Assuming that the p-type layer is 150Å in thickness and the deposition rate is 500Å per minute, the period of time to deposit the p-type layer is approximately 0.3 minutes. For an intrinsic layer of 2,700Å at a deposition rate of 220Å/min., the time period to deposit the intrinsic layer is approximately 12.3 minutes. Assuming an n-type layer of 250Å at a deposition rate of 500Å per minute, it will require approximately 0.5 minute to deposit the n-type layer. It can therefore be seen that if one chamber is dedicated to the deposition of a p-type layer and multiple chambers are dedicated to the deposition of the intrinsic and n-type layers, an increased throughput of substrates can be realized by increasing the number of processing chambers that can produce the i-n layers in parallel. That is, a continuous series of substrates can be loaded and maneuvered by the transfer chamber 870 from a process chamber that is adapted to deposit a p-type layer, such as process chamber 881, and then each of the substrates can be transferred to at least one subsequent processing chamber, such as process chambers 882 through 848 and 846 to 487 to form the i-n layers.

In light of the above, a plurality of embodiments has been described. According to one embodiment a method of manufacturing a layer stack adapted for a thin-film solar cell is provided the method includes depositing a TCO layer over a transparent substrate, depositing a first conductive-type layer a first p-i-n junction configured for the solar cell, depositing a first intrinsic-type layer of a first p-i-n junction configured for the solar cell, and depositing a further conductive-layer with a conductivity opposite to the first conductive-type layer first p-i-n junction configured for the solar cell. The method further includes providing for a SiOx-containing intermediate layer by chemical vapor deposition and depositing a second p-i-n junction configured for the solar cell, wherein the SiOx-containing intermediate layer is provided as a part of the further conductive-type layer, and wherein the SiOx-containing layer has a thickness of 17 nm or less. Typically, the intermediate layer can be provided with a layer of the further conductive type or between such a layer of the further conductive type in order to form a part or portion of the further conductive-type layer. According to yet further embodiments, which can be combined with other embodiments described herein, the method can further include providing a hydrogen-dilution grading in an intrinsic layer of the first p-i-n junction and/or the second p-i-n junction; further the SiOx-containing intermediate layer can be a microcrystalline SiOx layer having a microcrystalline fraction of 30% or below, typically of about 2%; the depositing the SiOx-containing intermediate layer can include flowing a gas mixture including at least silane, hydrogen and CO2 in a deposition region of the chemical vapor deposition process; and/or the SiOx-containing intermediate layer can be deposited to have a refraction index of 2.5 or less.

According to another embodiment, a precursor for a solar cell is provided. The precursor includes a transparent substrate, a first conductive-type layer a first p-i-n junction configured for the solar cell, a first intrinsic-type layer of a first p-i-n junction configured for the solar cell, and a further conductive-layer with a conductivity opposite to the first conductive-type layer first p-i-n junction configured for the solar cell. The precursor further includes a SiOx-containing intermediate layer deposited by chemical vapor deposition, and a second p-i-n junction configured for the solar cell, wherein the SiOx-containing intermediate layer is provided a s a part of the further conductive-type layer, and wherein the SiOx-containing layer has a thickness of 17 nm or less. According to a modification thereof, the precursor can further include a hydrogen-dilution grading in at least one of the intrinsic layers of the first and the second p-i-n junctions. According to yet further embodiments, which can be combined with other embodiments described herein, the SiOx-containing intermediate layer can be a microcrystalline SiOx layer having a microcrystalline fraction of 0.2 or below; the SiOx-containing intermediate layer can include carbon; the SiOx-containing intermediate layer can have a refraction index of 2.5 or less; the SiOx-containing intermediate layer can be a wavelength-dependent reflection layer; the SiOx-containing intermediate layer can be an doped layer, particularly a doped layer of the further conductive type; and/or the SiOx-containing intermediate layer has a thickness of 5 nm to 15 nm.

While the foregoing is directed to embodiments of the present invention, other and further embodiments of the invention may be devised without departing from the basic scope thereof, and the scope thereof is determined by the claims that follow.

## Claims

1. A method of manufacturing a layer stack adapted for a thin-film solar cell, the method comprising:
depositing a TCO layer over a transparent substrate;
depositing a first conductive-type layer a first p-i-n junction configured for the solar cell;
depositing a first intrinsic-type layer of a first p-i-n junction configured for the solar cell;
depositing a further conductive-layer with a conductivity opposite to the first conductive-type layer first p-i-n junction configured for the solar cell;
providing for a SiOx-containing intermediate layer by chemical vapor deposition; and
depositing a second p-i-n junction configured for the solar cell;
wherein the SiOx-containing intermediate layer is provided as a part of the further conductive-type layer, and wherein the SiOx-containing layer has a thickness of 17 nm or less.

2. The method according to claim 1, further comprising:
providing a hydrogen-dilution grading in an intrinsic layer of the first pi-n junction and/or the second p-i-n junction.

3. The method according to any of claims 1 to 2, wherein the SiOx-containing intermediate layer is a microcrystalline SiOx layer having a microcrystalline fraction of 30% or below, typically of about 2%.

4. The method according to any of claims 1 to 3, wherein the depositing the SiOx-containing intermediate layer comprises:
flowing a gas mixture comprising at least silane, hydrogen and CO2 in a deposition region of the chemical vapor deposition process.

5. The method according to any of claims 1 to 4, wherein the SiOx-containing intermediate layer is deposited to have a refraction index of 2.5 or less.

6. A precursor for a solar cell, comprising:
a transparent substrate;
a first conductive-type layer a first p-i-n junction configured for the solar cell;
a first intrinsic-type layer of a first p-i-n junction configured for the solar cell;
a further conductive-layer with a conductivity opposite to the first conductive-type layer first p-i-n junction configured for the solar cell;
a SiOx-containing intermediate layer deposited by chemical vapor deposition; and
a second p-i-n junction configured for the solar cell;
wherein the SiOx-containing intermediate layer is provided a s a part of the further conductive-type layer, and wherein the SiOx-containing layer has a thickness of 17 nm or less.

7. The precursor according to claim 6, further comprising:
a hydrogen-dilution grading in at least one of the intrinsic layers of the first and the second p-i-n junctions.

8. The precursor according to any of claims 6 to 7, wherein the SiOx-containing intermediate layer is a microcrystalline SiOx layer having a microcrystalline fraction of 0.2 or below.

9. The precursor according to any of claims 6 to 8, wherein the SiOx-containing intermediate layer comprises carbon.

10. The precursor according to any of claims 6 to 9, wherein the SiOx-containing intermediate layer has a refraction index of 2.5 or less.

11. The precursor according to any of claims 6 to 10, wherein SiOx-containing intermediate layer is a wavelength-dependent reflection layer.

12. The precursor according to any of claims 6 to 11, wherein the SiOx-containing intermediate layer is a doped layer, particularly a doped layer of the further conductive type.

13. The precursor according to any of claims 6 to 12, wherein the SiOx-containing intermediate layer has a thickness of 5 nm to 15 nm.
